# EUROPEAN PATENT APPLICATION

(11) **EP 1 184 725 A1**
(43) Date of publication of application: **06.03.2002**
(21) Application number: 00119138.6
(22) Date of filing: 04.09.2000
(51) Int. Cl.: G03F 7/20

(54) **Method for adjusting a lithographic tool**

(71) Applicant: Infineon Technologies SC300 GmbH & Co. KG, 01099 Dresden (DE); Infineon Technologies AG, 81669 München (DE); MOTOROLA, INC., Schaumburg, IL 60196 (US)
(72) Inventor: Maltabes, John, 01277 Dresden (DE); Schedel, Thorsten, 01109 Dresden (DE); Ganz, Dietmar, 01099 Dresden (DE)
(74) Representative: Fischer, Volker, Dipl.-Ing.

(57) **Abstract**

For adjusting a lithographic tool (11) a method is provided, in which inspected wafer images of an defect inspection tool (20, 20') are correlated with images from a reference library in database (202), each reference image corresponding to an initially measured amount of misadjustment of lithographic tool parameters. The lithographic tool (11) is adjusted automatedly according to the reference image found with largest resemblance to the wafer image. Time for adjusting is saved, operator staff needed is reduced, and objective determination criteria provide high wafer quality and yield.

## Description

The present invention relates to a method for adjusting a lithographic tool.

In semiconductor wafer fabrication process the role of wafer inspection becomes increasingly important with the rapid advent to smaller linewidths. Optical and deep-ultraviolet (DUV) defect inspection tools and microscopes are now supplemented by scanning electron microscopes (SEM) and atomic force microscopes (AFM) with the effect of growing complexity and expense of wafer and tool qualification.

By inspecting specially designed test wafers or normal blank wafers for test purposes, tool checks of lithographic tools can be achieved on a routine basis. For this purpose special masks are supplied by a mask manufacturer, which contain test patterns, that allow to easily identify exposure step characteristics, e.g. grating type or clear masks. Non-productive test wafers are exposed to light utilising these patterned masks either triggered by time or by event.

The patterns transposed to the wafers allow to perform individual tests, when the corresponding wafers are inspected with an inspection tool. E.g., with a chessboard-like pattern scan errors in either x- or y-direction may be identified. With grating type patterns or clear mask exposures the uniformity can be checked. Focus tests, overlay tests, chuck contamination tests etc. can also be performed with corresponding patterned exposures and following inspection.

Usually, engineers or operators inspect the wafers visually with a microscope and decide with their individual experience, whether actions are taken or not in case a process window seems to be left, tool errors accumulate or particle contamination increases beyond a threshold value. Typical actions are the adjustment of focus, dose, stage tilt or other machine parameters in the exposure tool, the cleaning of equipment, or system maintenance by the equipment manufacturer.

Modern semiconductor defect inspection tools like scanning electron microscopes provide the functionality of pattern fidelity analysis, e.g. by image or scan correlation, but it is up to an engineer to interpret the analysis in terms of lithographic tool parameter adjustments. The inevitable use of subjective criteria from operator to operator when making a determination of adjustments renders objective statistical monitoring procedures impossible. Thus, drifts of process parameters may be recognised too late or might even not be perceived at all due to the complicated interrelation of parameters in the underlying process model, thereby reducing the wafer quality and yield. Moreover, an operator based determination is time consuming especially when the additional consulting of engineers and the communication of actions to be taken by the exposure tool operator staff is considered.

In US 5,655,110 a method is demonstrated where statistical distributions of critical dimension values in wafer mask production are traced back to a set of matched process model tool parameters with the help of statistical analysis. Those tool parameters are identified, which contribute strongest to variances, and are adjusted in order to reduce critical dimension variances. While this approach allows for a fast on-line reaction to process parameter drifts, it is restricted to mass-production lines not allowing for intermediately changing setups, and especially cannot identify parameters, which may not be otherwise identified due to an insignificant critical dimension difference. Moreover, local defects or particle contamination problems may not generally be detected in critical dimension measurements.

It is therefore a primary object of this invention to provide a method for adjusting a lithographic tool, which improves the wafer quality and yield, and reduces the amount of rework as well as time needed to maintain optimal process parameters.

The objective is solved by a method for adjusting a lithographic tool, characterised in that in a first step a wafer image, which is taken from a wafer by an inspection tool, is correlated with reference images provided from an image library with each test image corresponding to an amount of mis-sadjustment of at least one lithographic tool parameter, and that in a second step, that reference image is selected, which provides a largest correlation with that wafer image, and that in a third step the lithographic tool is adjusted by correcting for the amount of misadjustment, that is attached to said selected reference image.

According to the present invention a method is provided, that leads to a fast and efficient adjustment of tool parameters in a wafer processing sequence, comprising an exposure tool like a wafer 1:1-projection system, stepper or scanner, and possibly an etching and developing tool. The corresponding tool checks to identify the parameter to be adjusted are performed by taking images of specific test wafers on inspection tools, and correlating these images with a set of reference images from an image library. To each of these reference images is attached the information of how much readjustment of at least one of the lithographic tools in the processing sequence is necessary in order to bring the wafer processing sequence of lithography tools back to a condition, where wafer quality parameters like critical dimension, registration, uniformity, defect density etc. are optimal.

With choosing that reference image, which provides the largest correlation with the test wafer image, the amount of readjustment for the lithography tools is known from the attached information. Thus, the adjustment of the lithography tool parameters does not depend on any operator's or engineer's subjective determination, but on an objective, repeatable, automated process. Advantageously, this enables statistical monitoring of process parameters, because parameter values and adjustments from different time intervals become comparable to each other. With the help of statistical parameter monitoring general problems and features may easily be identified. Thus, yield and quality of wafer production are significantly improved.

Once some effort has been spent in setting up the image library by attaching information of misadjustment or readjustment necessary to the reference images, the whole method can run down automatically without the need for visual inspection by the operators, interpreting the results in terms of lithography tool readjustments, and communicating the requirements of readjusting to the lithography tool operators. Therefore, time and personnel resources are saved.

Additionally, since the image library may be enlarged, the method can be refined and adapted to include new parameters, which have not been tracked before. The versatility of the method stems from the feature, that lithographic tool parameter specific test patterns are used for the wafers, such that any new test pattern identifying another lithography tool parameter can be easily incorporated into the method. Thus, the method relies on a very broad range of information, instead of being based upon just one wafer quality parameter like critical dimension. Also, the actions taken vary from adjusting continuous lithography tool parameters like focus or those, to simply stopping the processing machine for cleaning, etc. Starting from lithography tool parameter conditions known to give optimal output in wafer quality, different wafers are exposed to light, then etched or developed each of them reflecting stepwise changed lithography tool parameters. The amount of intendedly misadjusted tool parameter values then provides the amount of readjustment necessary to return to the optimal condition of the lithographic tool for each image. For this procedure are only relative deviations to an optimal or nominal condition needed, rendering an absolute recalibration of the lithographic tool unnecessary.

An analogous aspect considers the case of particle contamination, scan or step errors. Using a suitable test pattern each wafer is exposed to light, etched and developed with various kinds of defects, which are attached to each wafer. Because two wafers reflecting the same kind of defect do not correlate well due to the errors being located at different locations, the image library also comprises images which just cover a region of interest. The correlation procedure will then be supplemented by feature recognition analysis. Thus, defects, particles or pattern errors occurring at the same time on the test wafer can be detected nearly simultaneously by comparing the wafer image with the reference image, resulting in the detection of the location of these occurrences. And in a further step these occurrences can be identified by correlating high resolution feature images of these occurrences with the reference feature images from the image library. This has the advantage, that defect and pattern error analysis can be statistically monitored efficiently, and adjustments or reactions on the lithographic tool can be performed quickly.

In a further aspect imaging with optical or deep-ultraviolet defect inspection tools is considered. Since the corresponding wafer images may cover the whole wafer field, and the image pixels can have only two values, the first with a signal detected above a threshold value and the second detected below the threshold value, the correlation of wafer images and reference images becomes straightforward.

A further aspect considers the case of more advanced microscope techniques. High resolution of regions of interest images covering greyscale values per pixel can be captured and compared to library images. This method is especially advantagous in cases, where the focus is monitored, because simple critical dimension measurements do not provide enough information about a defocus, but a correlation of high resolution images provides detailed information about focus drifts.

A further aspect considers a preferred procedure for analysing, determining and adjusting the wafer and tool parameters using a control unit. It receives the information, which is attached to the selected image, from the inspection tool, derives actual lithographic tool parameter conditions from said information and compares them with values of the nominal condition. Then, it identifies lithographic tool parameters to be changed and derives control signals from deviations in actual and nominal condition values, transmits said control signals to the lithographic tool to control lithographic tool parameters.

This control unit is advantageous, when commonly existing control elements like a local defect inspection host computer and a fab-wide manufacturing execution system as constituent parts of the unit are combined in order to perform the logical tasks of the closed loop control circuit according to this invention.

A further advantageous aspect considers the automatic repeating of the three main steps of the method of this invention after processing a number of production wafers. An event is issued by the control unit or the defect inspection host resulting in a start of a new test wafer to be exposed with a test pattern on the lithographic tool. If an image library for production wafers exists, a tool check could also be posted for a production wafer after having processed a number of production wafers.

A further advantageous aspect is the employment of at least one neuronal network on the aforementioned defect inspection host. The method can be based on a self-learning method by training the system with any of the reference images and it's meaning in terms of misadjustment. Also, by autonomously grouping new images - reference, test or production - the system learns to classify an image under inspection, and can therefore support the task of parameter identification of the control unit.

An embodiment of the invention is now described with reference to the drawing. In the drawing:

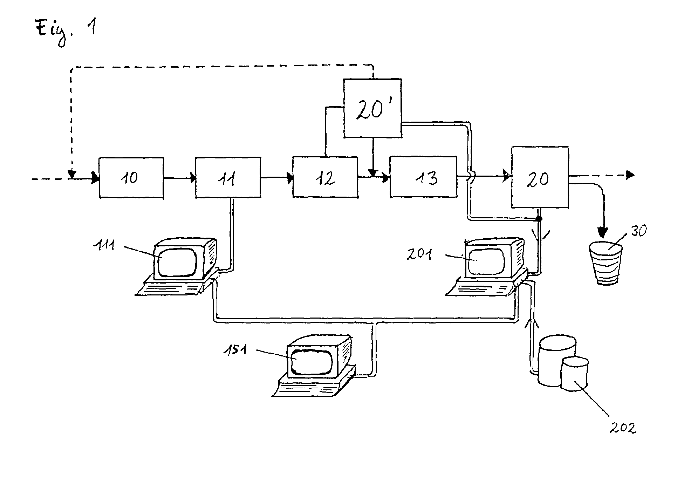

- Figure 1: shows a schematic view of wafer and information flow according to the invention.

In what follows, an embodiment is described with respect to adjusting focus parameters of a lithographic tool. Several lots of production wafers move on their processing sequence via the processing steps of coating 10, exposure to light 11, developing 12, etching 13 and defect inspection 20, shown in figure 1, at least once, depending on the number of mask levels to be received. After a certain time interval, e.g. on a daily basis, single test wafer lots are started on coaters 10. After being coated the test wafers are exposed to light in exposure tools 11, which are preferably wafer 1:1-projection exposure tools, steppers or scanners, or electron beam writers. To perform tool checks and adjustments grating type masks or reticles are used for patterning.

After being processed through the developing tools 12, the focus test wafers can be inspected on inspection tools 20' for controlling the lithography step. In case the exposure has been insufficient, the wafer can be sent back to the coater on a rework route, and the process sequence can be repeated. Thereafter the wafer is processed on the etching tools 13 followed by a new inspection on the inspection tools 20 for performing an etch or lithography control. The inspection according to the method of the present invention can be carried out after developing or etching the wafer.

For focus tests scanning electron microscopes are preferably used as inspection tools 20, but other inspection tools like optical scatterometers are suited as well. Having performed a first low resolution optical inspection, a high resolution image in a region of interest is taken. The imaging is controlled and digitised by the defect inspection host 201.

Attached to the defect inspection host 201 is a database 202 comprising an image library. This image library is set up in advance of any routine tool check inspection. Concerning focus tests a set of reference images is stored in the database 202, where each reference image reflects one reference focus test wafer, the reference focus test wafers being exposed to light in exposure tools 11, each with a certain misadjustment of the lithography tool focus parameter.

The establishing of the database can have taken place on occasion of exposure tool 11 calibration setups, when a nominal condition was known, defined as the set of lithography tool parameters, which provide best quality output of wafers in terms of critical dimension, registrations, uniformity etc. The database is increasing with time in that single reference images can be added to the database, if amounts of misadjustments of focus test wafers are explicitly known in certain instances.

After the imaging step defect inspection host 201 issues a notification to a control host 151, which is part of the manufacturing execution system the notification consists of the test lot number, the process conditions identification, the test type performed, the name of one or more parameters, that have to be adjusted, and the corresponding amounts of readjustments. The defect inspection host 201 and the control host 151 together serve as a control unit controlling the actions to be taken on exposure tools 11. Thereby, control host 151 decides, whether the readjustment necessary to bring the system back into in nominal condition, is significant enough to be posted to the exposure tool. If a readjustment is necessary, a corresponding notification is sent to the exposure tool host 111. There, the readjustment of focus parameters of exposure tool 11 is either performed manually by the operators receiving the message on exposure tool host 111, or is performed directly by an automation link from exposure tool host 111 and exposure tool 11.

The information received by control host 151 from defect inspection host 201 can further be analysed by a statistical process control tool in order to further identify general problems of the system in case same parameters have repeatedly to be adjusted.

Moreover, the time interval between two test wafer lot starts each consisting of at least one wafer can also be adapted to the amount of readjustments of exposure tools 11. E.g., if there are no adjustments necessary, the system is obviously stable, and the time interval can be enlarged, thereby improving characteristics of overall equipment efficiency.

The embodiment according to the invention described so far guarantees a fast and repeatable reaction to lithographic tool parameter drifts. Thus, time is saved, operator staff is reduced, and wafer production quality and yield is improved. The embodiment and the method can still be improved, if a set of images of production wafers can be established and added to the database comprising the image library. In this case the disposal 30 for test wafers after inspection would be rendered unnecessary.

## Claims

1. Method for adjusting a lithographic tool (11),
**characterised in that**
- in a first step a wafer image, which is taken from a wafer by an inspection tool (20, 20'), is correlated with reference images provided from an image library with each test image corresponding to an amount of misadjustment of at least one lithographic tool parameter,
- in a second step that reference image is selected, which provides a largest correlation with said wafer image,
- in a third step the lithographic tool (11) is adjusted by correcting for the amount of misadjustment that is attached to said selected reference image.

2. Method for adjusting a lithographic tool (11) according to claim 1,
**characterised in that**
- the image library comprises a set of reference images, each reference image being taken from different wafers, which are each exposed, etched or developed under changing lithographic tool parameter conditions,
- each reference image of said set of reference images is assigned with the grade of deviation towards a nominal condition, said nominal condition being the set of lithographic tool parameters represented by the best quality reference image.

3. Method for adjusting a lithographic tool (11) according to claim 1,
**characterised in that**
- the image library comprises said set of reference images, each reference image being taken from different wafers, which are each exposed, etched or developed under changing conditions of particle contamination, scan or step errors,
- the reference images are each assigned with a classification of said particle contamination, scan or step errors.

4. Method for adjusting a lithographic tool (11) according to anyone of claims 1 to 3,
**characterised in that**
the inspection tool (20') performs the step of taking the wafer image or reference image in optical or deep-ultraviolet light.

5. Method for adjusting a lithographic tool (11) according to anyone of claims 1 to 3,
**characterised in that**
the inspection tool (20) is a scanning electron microscope, an atomic force microscope or a scatterometer, and full-field images or high-resolution scans are captured as wafer or reference images.

6. Method for adjusting a lithographic tool (11) according to anyone of claims 2 to 5,
**characterised in that**
- a control unit (151, 201) receives the information, which is attached to the selected image, from the inspection tool (20, 20'),
- the control unit (151, 201) derives actual lithographic tool parameter conditions from said information and compares them with values of the nominal condition,
- the control unit (151, 201) identifies lithographic tool parameters to be changed and derives control signals from deviations in actual and nominal condition values,
- the control unit (151, 201) transmits said control signals to the lithographic tool (11) to control lithographic tool parameters.

7. Method for adjusting a lithographic tool (11) according to anyone of claims 1 to 6,
**characterised in that**
a number of production wafers is processed on the lithographic tool (11) without performing one of the first, second or third step, and then the first, second and third step are performed on said wafer.

8. Method for adjusting a lithographic tool (11) according to claim 7,
**characterised in that**
the control unit (151, 201) comprises a neuronal network, which is trained with at least one of said reference images and the related amount of misadjustment, and which is used to identify lithographic tool parameters to be changed.
